(19)

**Europäisches Patentamt**

**European Patent Office**

**Office européen des brevets**

(11)  **EP 3 864 387 B1**

(12)  **FASCICULE DE BREVET EUROPEEN**

(45) Date de publication et mention
de la délivrance du brevet:
**19.07.2023   Bulletin 2023/29**

(21) Numéro de dépôt: **19829295.5**

(22) Date de dépôt: **21.11.2019**

(51) Classification Internationale des Brevets (IPC):
*G01J 5/02* *(2022.01)*      *G01J 5/08* *(2022.01)*
*G01J 5/20* *(2006.01)*      *G01J 5/24* *(2006.01)*

(52) Classification Coopérative des Brevets (CPC):
**G01J 5/024; G01J 5/0853; G01J 5/20; G01J 5/24**

(86) Numéro de dépôt international:
**PCT/FR2019/052776**

(87) Numéro de publication internationale:
**WO 2020/109704 (04.06.2020 Gazette 2020/23)**

(54) **STRUCTURE DE DÉTECTION DE RAYONNEMENT ÉLECTROMAGNÉTIQUE À ABSORPTION OPTIMISÉE ET PROCÉDÉ DE FORMATION D'UNE TELLE STRUCTURE**

STRUKTUR ZUR DETEKTION VON ELEKTROMAGNETISCHER STRAHLUNG MIT OPTIMIERTER ABSORPTION UND VERFAHREN ZUR HERSTELLUNG SOLCH EINER STRUKTUR

ELECTROMAGNETIC RADIATION DETECTION STRUCTURE WITH OPTIMISED ABSORPTION AND METHOD FOR FORMING SUCH A STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **28.11.2018   FR 1872024**

(43) Date de publication de la demande:
**18.08.2021   Bulletin 2021/33**

(73) Titulaire: **Commissariat à l'énergie atomique et aux énergies alternatives**
**75015 Paris (FR)**

(72) Inventeurs:
• **ALIANE, Abdelkader**
  **38054 GRENOBLE CEDEX 09 (FR)**
• **OUVRIER-BUFFET, Jean-Louis**
  **38054 GRENOBLE CEDEX 09 (FR)**
• **VIALLE, Claire**
  **38054 GRENOBLE CEDEX 09 (FR)**

(74) Mandataire: **Brevalex**
**Tour Trinity**
**1 Bis Esplanade de La Défense**
**CS 60347**
**92035 Paris La Défense Cedex (FR)**

(56) Documents cités:
**WO-A1-2018/055276      US-A1- 2015 153 236**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

Cette invention résulte d'un marché passé par le Ministère de la Défense qui dispose de certains droits dessus.

## Domaine technique

L'invention concerne les structures de détection de rayonnement électromagnétique notamment dans le domaine des infrarouges.

L'invention a ainsi plus précisément pour objet une structure de détection de rayonnement électromagnétique et un procédé de fabrication d'une telle structure.

## Domaine technique

Afin de détecter les rayonnements électromagnétiques, notamment dans la gamme de longueurs d'onde de l'infrarouge, il est connu d'utiliser des structures de détection de rayonnement électromagnétique de type bolomètre.

Une telle structure comporte :

- un élément absorbant configuré pour absorber le rayonnement électromagnétique, généralement fourni sous la forme d'une membrane suspendue,
- un transducteur présentant une caractéristique qui varie avec la température, le transducteur étant associé à l'élément absorbant afin de permettre une détection de l'élévation de température dudit élément absorbant lors de l'absorption du rayonnement électromagnétique.

Afin d'autoriser une réduction de la taille de ces structures, il a été récemment proposé l'utilisation de transistors MOS-FET en tant que transducteur.

Conformément au document WO2018055276 A1, le transistor d'une structure selon une telle possibilité comprend :

◦ au moins une première et au moins une deuxième zone d'un premier type de conductivité,
◦ au moins une troisième zone séparant l'une de l'autre la première et la deuxième zone, la troisième zone étant d'un deuxième type de conductivité opposé au premier type de conductivité avec une concentration en porteurs majoritaires inférieure à celle des première et deuxième zones,
◦ au moins une première électrode de grille agencée pour polariser la troisième zone.

Au moins une métallisation d'un tel transistor, notamment l'électrode de grille, forme l'élément absorbant de la structure de détection.

Dans cette configuration, conformément à la figure 1B du document WO2018055276 A1, les première, troisième et quatrième zones se succèdent le long du plan d'absorption afin de former respectivement le drain, le canal et la source du transistor CMOS.

Si une structure de détection selon cette possibilité décrite dans le document WO2018055276 A1 permet de fournir une bonne absorption du rayonnement électromagnétique à détecter, ceci notamment par une optimisation de l'élément absorbant, cette absorption n'est toujours pas optimale.

En effet, si, conformément à son enseignement, il est possible de fournir un élément absorbant présentant une impédance proche de celle du vide, c'est-à-dire de l'ordre de 376,9 $\Omega$, l'impédance totale de la structure, qui est celle perçue par l'onde électromagnétique à absorber, est en réalité inférieure et ne permet donc pas d'obtenir une absorption optimale. Cette impédance fait en effet intervenir, en plus de l'élément absorbant, l'ensemble des éléments du transistor dont notamment les première et deuxième zones qui sont fortement dopées pour permettre un bon contact électrique et présente une siliciuration, non figurée dans ce document WO2018055276 A1, au niveau desdites zones peuvent diminuer drastiquement l'impédance. De ce fait la résistance équivalente perçue par le rayonnement électromagnétique est généralement comprise entre 1 et 100 $\Omega/\square$, ce qui est relativement éloigné des 376,9 $\Omega/\square$ qui seraient nécessaire pour optimiser l'absorption du rayonnement électromagnétique par l'élément absorbant.

## Exposé de l'invention

L'invention vise à remédier à cet inconvénient et a ainsi pour but de fournir une structure de détection comportant un transistor MOS-FET en tant que transducteur et qui est susceptible de présenter un taux d'absorption supérieur à une structure de l'art antérieur.

L'invention concerne à cet effet une structure de détection de type bolomètre pour la détection d'un rayonnement électromagnétique, la structure de détection comportant :

- au moins un élément absorbant configuré pour absorber le rayonnement électromagnétique et s'étendant sensiblement selon un plan d'absorption,
- un transistor du type MOS-FET associé avec le premier élément absorbant pour détecter l'élévation de température dudit élément absorbant lors de l'absorption du rayonnement électromagnétique par ce dernier, le transistor comportant :

o au moins une première et au moins une deuxième zone d'un premier type de conductivité,
o au moins une troisième zone séparant l'une de l'autre la première et la deuxième zone, la troisième zone étant d'un deuxième type de conductivité opposé au premier type de conductivité avec une concentration en porteurs majoritaires inférieure à celle des première et deuxième zone,

◦ une électrode de grille, agencée pour polariser la troisième zone.

La première zone, la troisième zone et la deuxième zone sont formées par respectivement par une première, une troisième et une deuxième couche qui s'étendent selon le plan d'absorption parallèlement les unes aux autres et qui se succèdent selon une direction perpendiculaire audit plan d'absorption, chacune desdites première, deuxième et troisième zones présentant, selon l'épaisseur de la couche correspondante, au moins une paroi latérale.

On notera que dans une configuration classique de l'invention la troisième zone présente une concentration en porteurs majoritaires significativement inférieure à celles des première et deuxième zones, c'est-à-dire inférieure à 10 fois celles des première et deuxième zones, voire 50 fois ou encore 100 fois celles desdites première et deuxième zones.

L'électrode de grille recouvre la troisième zone le long d'au moins une paroi latérale de ladite troisième zone.

Les inventeurs ont constaté que dans une structure telle que celle décrite dans le document WO2018055276 A1, les zones dopées, que sont les première et deuxième zones, ont un rôle prépondérant dans la baisse de l'impédance équivalente perçue par le rayonnement. Or, la configuration de l'invention permet un bon contrôle des dimensions de ces dernières, puisqu'elles sont fournies sous forme de couches. Ainsi, l'invention autorise, par la possibilité d'épaisseur réduite des première et deuxième zones à laquelle elle donne accès, de fournir des première et deuxième zone présentant un volume fortement réduit vis-vis des structures de l'art antérieur et donc avec une influence réduite de ces dernières sur l'impédance équivalente perçue par l'onde électromagnétique à absorber.

De plus, une telle configuration selon l'invention permet d'optimiser le rapport signal sur bruit de la structure. En effet, les travaux de L. Gitelman et de ses coauteurs publiés en 2009 dans la revue scientifique « IEEE transaction on electron devices » volume 56 numéro 9 pages 1935-1942, ont montré que la puissance équivalente du bruit, noté NEP dans le cadre de ces travaux, représentant l'inverse du signal sur bruit d'un tel transistor, varie inversement avec le courant drain-source et la puissance d'absorption.

Or, si une telle structure autorise une optimisation de la puissance d'absorption, ceci par la configuration des première et deuxième zones, elle autorise également une optimisation du courant drain-source qui est directement dépendant de la géométrie du transistor. En effet, le courant drain-source est proportionnel au rapport W/L avec W la largeur du canal et L la longueur du canal. Or dans la configuration de l'invention dans laquelle chacune des zones est formée par une couche respective, la longueur du canal L est égale à l'épaisseur de la troisième zone. Ainsi, par une géométrie adaptée du transistor, comme par exemple des première, deuxième et troisième zones en forme annulaire, qui permet d'optimiser la largeur du canal W, il est possible d'optimiser le courant drain-source en bénéficiant d'une longueur L minimale du canal offerte par la configuration de l'invention.

De cette manière, il est possible d'obtenir avec une structure selon l'invention une optimisation à la fois de l'absorption du rayonnement électromagnétique, ceci par une optimisation de l'impédance équivalente de l'élément absorbant qu'elle autorise, et du courant drain-source, de par l'optimisation de la longueur L du canal qu'elle autorise, vis-à-vis d'une structure de l'art antérieur comportant un transistor MOS-FET en tant que transducteur.

Selon le principe de fonctionnement général d'un transistor MOS-FET, l'électrode de grille est agencée pour polariser la troisième zone.

La troisième zone peut présenter au moins deux parois latérales, l'électrode de grille recouvrant la troisième zone le long d'au moins deux parois latérales de ladite troisième zone qui sont opposées l'une à l'autre.

De cette manière, le canal est formé au niveau de chacune des parois latérales. Ainsi, la largeur du canal W est multipliée par deux, puisque présent sur chacune des parois latérales, et le rapport W/L est lui-même multiplié par deux. Le courant drain-source en est donc optimisé.

L'élément absorbant peut comprendre une portion d'absorption s'étendant au-delà d'un empilement formé par les première, troisième et deuxième zones.

L'empilement formé par les première, troisième et deuxième zones peut entourer au moins en partie une zone de la structure dite d'absorption, la portion d'absorption s'étendant au moins en partie parallèlement à la zone d'absorption.

De cette manière au niveau de ladite zone d'absorption, l'empilement formé par les première, troisième et deuxième zones a peu, voire pas, d'influence sur l'impédance équivalente de l'élément absorbant perçu par le rayonnement électromagnétique à absorber. Ainsi, il est aisé de fournir une telle portion d'absorption avec une impédance équivalente proche de celle du vide.

L'électrode grille peut comprendre l'élément absorbant.

L'électrode de grille peut comprendre au moins une couche réalisée dans un métal « milieu de gap » pour au moins la troisième zone.

Un tel métal « milieu de gap » permet de réduire la tension de polarisation de la grille et donc la chaleur dégagée par le transistor en fonctionnement. Cette chaleur résiduelle du transistor étant réduite, elle influence peu la mesure de l'élévation de température provoquée par l'absorption du rayonnement par l'élément absorbant. Il en résulte une optimisation de la sensibilité de la structure selon l'invention.

La couche réalisée dans un métal « milieu de gap » peut être supporté par une couche diélectrique, le métal de la couche en métal « milieu de gap et les épaisseurs de ladite couche et de la couche diélectrique la supportant étant choisies de manière à respecter les inégalités suivantes :

$$150\Omega \leq \frac{\rho}{Ep} \leq 700\ \Omega$$

avec ρ la résistivité équivalente desdites couches et Ep la somme des épaisseurs desdites couches.

Le transistor peut comporter en outre un contact métallique pour la deuxième zone.

Le contact métallique de la deuxième zone peut comporter l'élément absorbant.

On notera que le transistor peut comporter un contact métallique pour la troisième zone. En variante, la troisième zone peut être laissée à un potentiel flottant

L'électrode de grille peut recouvrir également la première zone et former un contact métallique de ladite première zone.

L'élément absorbant peut comprendre une couche conductrice supportée par une couche isolante, le métal de la couche métallique et les épaisseurs de ladite couche métallique et de la couche isolante la supportant étant choisies de manière à respecter les inégalités suivantes :

$$150\Omega \leq \frac{\rho}{Ep} \leq 700\ \Omega$$

avec ρ la résistivité équivalente desdites couches et Ep la somme des épaisseurs desdites couches.

De cette manière, l'absorption du rayonnement électromagnétique par l'élément absorbant est optimisée.

L'invention concerne en outre un procédé de fabrication d'une structure de détection type bolomètre pour la détection d'un rayonnement électromagnétique, le procédé de fabrication comprenant les étapes suivantes :

- fourniture d'une deuxième zone d'un premier type de conductivité, ladite deuxième zone s'étendant selon un plan d'absorption, la deuxième zone étant formée d'une deuxième couche,
- formation d'une troisième zone en contact avec la deuxième zone, ladite troisième zone étant d'un deuxième type de conductivité opposé au premier type de conductivité avec une concentration en porteurs majoritaires inférieure à celle de la deuxième zone, la troisième zone étant formée d'une troisième couche,
- formation d'une première zone en contact avec la troisième couche, la première zone étant du premier type de conductivité avec une concentration en porteurs majoritaires supérieure à celle de la troisième zone et étant formée d'une première couche, de telle manière que chacune de la première zone, la deuxième zone et la troisième zone s'étendent parallèlement à un plan d'absorption et que la première, la troisième et la deuxième zone se succèdent selon une direction perpendiculaire audit plan d'absorption, chacune desdites première, deuxième et troisième zones présentant, selon l'épaisseur de la couche correspondante, au moins une paroi latérale,

- formation d'une électrode de grille recouvrant la troisième zone le long d'au moins une paroi latérale de ladite troisième zone ceci de manière à former un transistor du type MOS-FET comprenant les première, deuxième et troisième zone et l'électrode de grille, l'électrode de grille étant agencée pour polariser la troisième zone,

le procédé de fabrication comprenant en outre la formation d'un élément absorbant associé au transistor de telle manière que le transistor soit apte à détecter l'élévation de température dudit élément absorbant lors de l'absorption du rayonnement électromagnétique, ledit élément absorbant définissant le plan d'absorption.

Un tel procédé permet la formation d'une structure selon l'invention et qui, de ce fait, présente les avantages qui y sont liés.

Les étapes de fourniture et de formation des première, deuxième et troisième zones peuvent être concomitantes, ladite fourniture et lesdites formations étant réalisées par une gravure d'un empilement comprenant une deuxième, une troisième et une première couche.

De cette manière, l'empilement formé par les première, deuxième et troisième zones présente un flanc de gravure particulièrement adaptée pour favoriser la formation de l'électrode de grille.

La deuxième zone peut être fournie préalablement à la formation des troisième et première zones, la troisième zone étant formée par un dépôt sélectif sur au moins une portion de la deuxième zone et la première zone étant formée par un dépôt sélectif sur au moins une portion de la troisième zone.

Ainsi, avec un tel procédé, les première, deuxième et troisième zones n'ont pas à présenter une largeur identique.

**Brève description des dessins**

La présente invention sera mieux comprise à la lecture de la description d'exemples de réalisation, donnés à titre purement indicatif et nullement limitatif, en faisant référence aux dessins annexés sur lesquels :

- la figure 1 illustre, en vue en coupe transversale, une structure de détection selon l'invention,
- les figures 2A à 2B illustrent un transistor MOS-FET d'une structure de détection telle qu'illustrée sur la figure 1 ceci avant la formation de sa grille et de ses métallisations selon respectivement une vue en coupe transversale et une vue de dessus,

- les figures 3A à 3M illustrent, au moyen de vues en coupe transversale, les étapes préliminaires de formation d'un substrat intermédiaire pour la formation d'un transistor MOS-FET d'une structure de détection telle qu'illustrée sur la figure 1,
- les figures 4A à 4T illustrent, au moyen de vues en coupe transversale, les étapes de formation d'un substrat de commande, d'assemblage dudit substrat de commande avec le substrat intermédiaire illustré sur la figure 3M et de finalisation de la structure de détection illustrée sur la figure 1,
- les figures 5A à 5G illustrent, au moyen de vues en coupe transversale, les étapes préliminaires de formation d'un substrat intermédiaire pour la formation d'un transistor MOS-FET d'une structure de détection selon une variante de l'invention.

Des parties identiques, similaires ou équivalentes des différentes figures portent les mêmes références numériques de façon à faciliter le passage d'une figure à l'autre.

Les différentes parties représentées sur les figures ne sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## Exposé détaillé de modes de réalisation particuliers

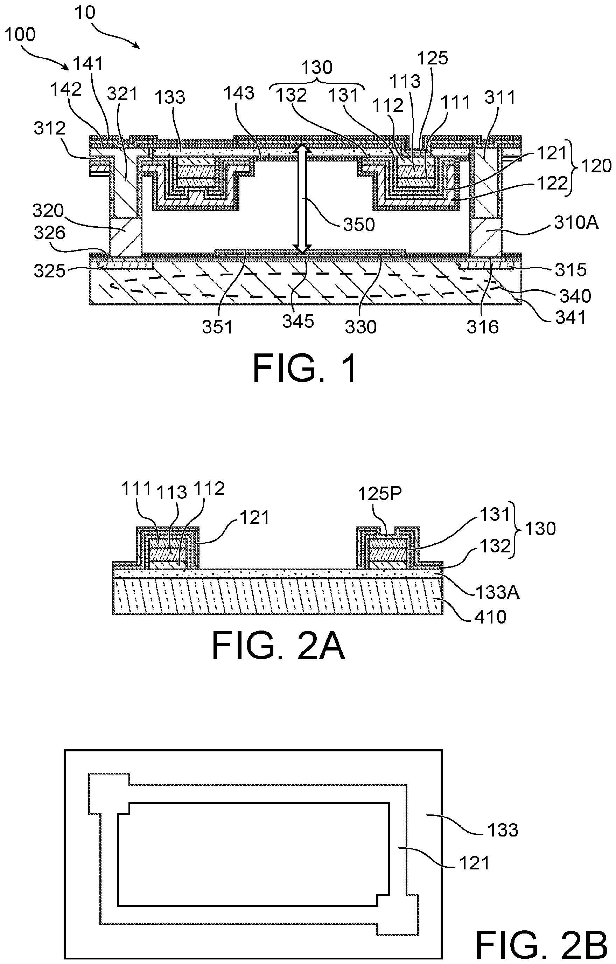

La figure 1 illustre schématiquement une structure de détection 10 de type bolomètre selon l'invention, une telle structure de détection 10 étant adaptée pour la détection d'un rayonnement électromagnétique.

Une telle structure de détection 10 vise plus particulièrement la détection de rayonnements électromagnétiques dans la gamme de longueurs d'onde des infrarouges. Ainsi, les différentes valeurs indiquées dans les modes de réalisation décrits ci-après concernent cette application pratique, dans laquelle la gamme de longueurs d'onde visée est l'infrarouge lointain, c'est-à-dire entre 8 et 12 $\mu$m. Bien entendu, ces valeurs ne sont fournies qu'à titre d'exemple non limitatif, l'homme du métier étant parfaitement à même, à partir de la présente divulgation, d'adapter ces valeurs afin de permettre à l'aide d'une telle structure de détection 10 la détection optimisée de rayonnements électromagnétiques dans une gamme de longueurs d'onde autre que celle des infrarouges.

Une telle structure de détection 10 comporte :

- un transistor 100 du type MOS-FET associé avec un premier élément absorbant pour détecter l'élévation de température dudit élément absorbant lors de l'absorption du rayonnement électromagnétique par ce dernier, le transistor comportant :

  ◦ au moins une première et au moins une deuxième zone 111, 112 d'un premier type de conductivité,
  ◦ au moins une troisième zone 113 séparant l'une de l'autre la première et la deuxième zone 111, 112, la troisième zone 113 étant d'un deuxième type de conductivité opposé au premier type de conductivité avec une concentration en porteurs majoritaires inférieure à celles des première et deuxième zones,
  ◦ un oxyde de grille 130,
  ◦ une électrode de grille 120 comprenant un premier élément absorbant 121, l'électrode de grille 120 formant en outre un contact ohmique de la première zone 111,
  ◦ un contact ohmique 125 de la deuxième zone 112 formant un deuxième élément absorbant,

- un premier et un deuxième bras d'isolation thermique 310, 320 comportant respectivement une première et une deuxième piste de conduction 311, 321 pour permettre la polarisation du transistor 100, la première piste 311 étant connectée à la deuxième zone 112, la deuxième piste 321 étant connectée à la première zone 111 et l'électrode de grille 120 en les mettant en court-circuit,
- une surface de réflexion 330 optionnelle disposée de manière à former avec le deuxième élément absorbant une cavité quart-d'onde 350,
- un circuit de lecture 340 dont seul le substrat 341 est figuré, le circuit de lecture 340 étant connecté électriquement aux première et deuxième pistes de conduction 311, 321 par l'intermédiaire de respectivement d'une première et une deuxième zone de contact 315, 325.

Dans une telle structure de détection 10, le contact ohmique 125 de la deuxième zone 112 s'étend, au moins pour sa partie formant respectivement le deuxième élément absorbant, selon un plan définissant un plan d'absorption. On notera, en particulier, que sur la figure 1, le plan d'absorption est défini par la partie du contact ohmique 125 de la deuxième zone 112, c'est-à-dire le deuxième élément d'absorption, s'étendant le long d'une zone de la structure entourée par l'empilement formé par les première, deuxième et troisième couches 111P, 112P, 113P, ladite zone étant dite zone d'absorption.

On notera que, selon l'application pratique de l'invention, la structure 10 présente des dimensions latérales, c'est-à-dire selon les directions comprissent dans le plan d'absorption, comprissent entre 4 et 10 $\mu$m.

Selon le principe de l'invention et, comme illustré sur les figures 1 et 2A, la première zone 111, la troisième zone 113 et la deuxième zone 112 sont formées par respectivement par une première, une troisième et une deuxième couche 111P, 112P, 113P qui s'étendent selon le plan d'absorption parallèlement les unes aux autres et qui se succèdent selon une direction perpendiculaire audit plan d'absorption, chacune desdites première, deuxième et troisième zones 111, 112, 113 présentant, selon l'épaisseur de la couche correspondante, au moins une paroi latérale.

Autrement, chacune de la première couche, de la deuxième couche et de la troisième couche 111P, 112P, 113P s'étendent parallèlement au plan d'absorption et la première couche 111P, la troisième couche 113P et la deuxième couche 112P se succédant selon une direction perpendiculaire audit plan d'absorption.

Chacune de la première, de la deuxième et de la troisième couche 111P, 112P, 113P est une couche semiconductrice, lesdites première, deuxième et troisième couches 111P, 112P, 113P, étant préférentiellement réalisées en silicium Si monocristallin.

Selon une première possibilité de l'invention, la première et la deuxième couche 111P, 112P présentent un premier type de conductivité pour lequel les porteurs majoritaires sont des électrons, ou, autrement dit, la première et la deuxième couche 111P, 112P sont dopées N. En variante et selon une deuxième possibilité de l'invention, la première et la deuxième couche 111P, 112P peuvent présenter un premier type de conductivité pour lequel les porteurs majoritaires sont des trous, ou, autrement dit, la première et la deuxième couches 111P, 112P sont dopées P.

On notera que selon l'application pratique de l'invention, la première et la deuxième couche 111P, 112P présente un dopage N avec une concentration en porteurs majoritaires comprise entre $1.10^{19}$ et $1.10^{21}$ $cm^{-3}$, Selon cette même application pratique de l'invention l'épaisseur desdites première et deuxième couche 111P, 112P est comprise entre 10 et 200 nm, voire entre 20 et 70 nm.

La troisième couche 113P peut, selon la première possibilité de l'invention, présente un deuxième type de conductivité opposé au premier type de conductivité, c'est-à-dire un type de conductivité dans lequel les porteurs sont des trous ou autrement dit un dopage P. D'une manière identique, selon la deuxième possibilité de l'invention, le deuxième type de conductivité opposé au premier type de conductivité, c'est-à-dire un type de conductivité dans lequel les porteurs majoritaires sont des électrons ou, autrement dit, un dopage N.

Selon l'application pratique, la troisième couche 113P présente un dopage P avec une concentration en porteurs majoritaires comprise entre $1.10^{14}$ et $1.10^{17}$ $cm^{-3}$, voire entre $5.10^{14}$ et $5.10^{15}$ $cm^{-3}$, ladite concentration étant, quoi qui l'en soit inférieure à celle des première et deuxième couches 111P, 112P. Selon cette même application pratique, l'épaisseur de la troisième couche 113P est comprise entre 10 et 500 nm, voire entre 50 et 250 nm ou encore entre 75 et 150 nm.

Comme illustré sur les figures 2A et 2B, un empilement formé par les première, deuxième et troisième couches 111P, 112P, 113P s'étend le long d'une ligne fermée qui est, selon la possibilité illustrée sur la figure 2B, rectangulaire. Bien entendu, une telle forme n'est fournie qu'à titre d'exemple et ledit empilement peut, bien entendu, s'étendre selon une autre forme, cette forme pouvant correspondre à une ligne ouverte ou fermée.

On notera néanmoins, que de manière préférentielle, l'empilement formé par les première, deuxième et troisième couches 111P, 112P, 113P est agencé pour entourer au moins en partie la zone de la structure de détection qui est dite zone de détection. Les parties de l'électrode de grille 120 et du contact ohmique 125 de la deuxième zone 112 formant le premier et le deuxième élément absorbant 121 s'étendent au moins en partie le long de ladite zone de détection. On notera que dans ce premier mode de réalisation, seule le deuxième élément absorbant s'étend entièrement le long de la zone de détection, le premier élément absorbant 121 présentant que des portions minoritaire s'étendant le long de la zone de détection.

Selon cette possibilité, l'empilement formé par les première, deuxième et troisième zones 111, 112, 113 peut par exemple présenter une configuration :

- en peigne, les zones du d'absorption entourées étant les zones disposées entre les bras du peigne, ou

en serpentin, les zones d'absorption entourées étant les zones définies entre les coudes du serpentin.

L'empilement formé par les première, deuxième et troisième zones 111, 112, 113 est, sur les parois latérales desdites zones et une face de l'empilement comprenant la première zone 111, recouvert par au moins un isolant 131, 132 formant, pour les parois latérales de la troisième zone un oxyde de grille 130.

Dans le présent mode de réalisation, l'au moins un isolant 131, 132 comprend une première couche isolante 131 en dioxyde de silicium et une deuxième couche isolante 132 dans un diélectrique présentant un coefficient diélectrique supérieur à celui du dioxyde de silicium, ce type de diélectrique étant généralement connu sous la dénomination high-K. Ainsi, la deuxième couche isolante 132 peut être, par exemple, un dioxyde d'hafnium $HfO_2$ ou un oxyde d'aluminium tel l'alumine $Al_2O_3$.

L'au moins isolant 131, 132 recouvrant l'empilement formé par les première, deuxième et troisième zones 111, 112, 113, présente au niveau de la face de l'empilement qu'il recouvre au moins une ouverture pour autoriser la prise de contact pour la première zone 111. L'au moins isolant 131, 132 est recouvert par l'électrode de grille 120, ladite électrode de grille 120 formant également le contact ohmique de la première zone 111.

On notera, selon le principe illustré sur la figure 2B, que l'empilement peut présenter au niveau desdites ouvertures, une largeur plus importante. Ainsi par exemple, selon l'application pratique de l'invention, l'empilement peut présenter sur les parties en dehors desdites ouvertures de prise de contact une largeur comprise entre 0,3 et 0,6 $\mu$m et sur les parties correspondant audites ouvertures, une largeur comprise entre 0,5 et 0,8 $\mu$m.

Selon ce mode de réalisation de l'invention, l'électrode de grille 120 comporte une première couche conductrice 121 en nitrure de titane TiN et une deuxième couche conductrice 122 en silicium polycristalin pSi, la première couche conductrice 121 recouvrant la deuxième couche isolante 132 et la deuxième couche conductrice 122 recouvrant la première couche conductrice 121.

Suivant l'enseignement du document WO2018055276 A1 et en prenant en compte la configuration de premier élément absorbant 121, de manière à favoriser les capacités d'absorption du premier élément absorbant, la première couche conductrice 121, la couche deuxième couche d'isolant 132 et une troisième couche d'isolant 133 qui la supporte sont choisies de manière à respecter les inégalités suivantes :

$$150\Omega \leq \frac{\rho}{Ep} \leq 700\ \Omega$$

avec $\rho$ la résistivité équivalente de la première couche conductrice 121, de la deuxième couche d'isolant 132 et de la troisième couche d'isolant 133 et Ep étant la somme de l'épaisseur de la première couche conductrice 121, de la deuxième couche d'isolant 132, et de la troisième couche d'isolant 133.la. On notera, que de manière encore plus préférentielle $\rho$/Ep est choisi proche, voire égale à 376,9 $\Omega$

De même, le matériau de la première couche conductrice 121 est préférentiellement un métal du type « milieu-de-gap » pour la troisième zone 113. Ainsi, dans le cas où la troisième zone 113 est en silicium, comme c'est le cas dans ce mode de réalisation de l'invention, le matériau de la première couche conductrice est préférentiellement un métal choisi dans le groupe comportant les nitrures de titane TiN, les nitrures de tantale TaN et les siliciures de molybdène $MoSi_2$.

On entend ci-dessus et dans le reste de ce document par « métal du type milieu-de-gap » que le métal est choisi de manière à présenter, en absence de polarisation de la structure, son énergie de Fermi dans la zone de bande interdite de la troisième zone 113 et plus précisément au voisinage du milieu de la bande interdite de la troisième zone 113, typiquement à un niveau d'énergie distant du milieu de la bande interdite dans une gamme comprise entre -25% et +25% du gap de la bande interdite. Une telle configuration de grille est généralement connue par l'homme du métier sous la dénomination anglaise de « mid-gap ». Ainsi dans le cas où la troisième zone est réalisée en silicium, les « métals du type milieu-de-gap » comportent notamment les nitrures de titane TiN, les nitrures de tantale TaN et les siliciures de molybdène $MoSi_2$.

Ainsi dans ce mode de réalisation de l'invention, la première couche conductrice 121 est préférentiellement réalisée en nitrure de titane TiN et comporte préférentiellement une épaisseur comprise entre 5 et 15 nm voire égale à 10 nm.

La deuxième couche conductrice 122, dans ce mode de réalisation de l'invention, est en silicium polycristalin pSi avec une épaisseur comprise entre 10 et 100 nm préférentiellement égale à 50 nm.

De manière à mettre en court-circuit la première zone 111 et l'électrode de grille 120, la première couche conductrice 121 est en contact avec la première zone 111 par l'au moins une ouverture ménagée dans l'au moins isolant 131, 132.

l'empilement est recouvert, sur l'une de ses faces comprenant la deuxième zone 112 et opposée à la première zone 111, d'au moins en partie par une troisième couche conductrice 125 formant le contact ohmique de la deuxième zone 112.

Suivant l'enseignement du document WO2018055276 A1 et d'une manière identique au premier élément absorbant 121, de manière à favoriser les capacités d'absorption du deuxième élément absorbant formé par la troisième couche conductrice 125, la troisième couche conductrice 125, et la troisième couche d'isolant 133 qui la supporte sont choisies de manière à respecter les inégalités suivantes :

$$150\Omega \leq \frac{\rho}{Ep} \leq 700\ \Omega$$

avec $\rho$ la résistivité équivalente de la première couche conductrice 121, de la deuxième couche d'isolant 132 et de la troisième couche d'isolant 133 et Ep étant la somme de l'épaisseur de la première couche conductrice 121, de la deuxième couche d'isolant 132, et de la troisième couche d'isolant 133.la. On notera, que de manière encore plus préférentielle $\rho$/Ep est choisi proche, voire égale à 376,9 $\Omega$

Ainsi, selon ce mode de réalisation de l'invention, la troisième couche conductrice 125 est réalisée en nitrure de titane TiN et présente une épaisseur comprise entre 5 et 15 nm et préférentiellement égale à 10 nm.

On notera que, en raison du procédé de fabrication préféré de l'invention, dans ce premier mode de réalisation, chacune de la deuxième couche conductrice 122 et de la troisième couche conductrice 125 est revêtue, sur sa surface qui est opposée à l'empilement, de respectivement une première couche de protection 143 et une deuxième couche de protection 141, telle qu'une couche en nitrure d'aluminium AlN, de dioxyde d'hafnium HfO2 ou de saphir $Al_2O_3$, apte à protéger lesdites couches conductrices 122, 125 lors d'une attaque acide telle qu'une attaque à l'acide fluorhydrique HF. Chacune des première et deuxième couches de protection 143, 141 présente une épaisseur comprise entre 10 et 50 nm et préférentiellement égale à 25 nm.

Pour les mêmes raisons et comme montré sur la figure 1, une troisième couche d'isolant 133, permettant notamment d'isoler la première piste de conduction 311 de la deuxième piste de conduction 321 et étant en contact de la deuxième zone 112 en la séparant, en dehors des parties où elles sont en contact, de la troisième couche conductrice 125, est revêtue d'une troisième couche de protection 142. Ainsi, comme illustré sur la figure 1, la troisième couche conductrice est entourée de la deuxième et de la troisième couche de protection 142, 141. D'une manière identique aux première et deuxième couches de protection 143, 141, la troisième couche peut être une couche en nitrure d'aluminium AlN, de dioxyde d'hafnium HfO2 ou de saphir $Al_2O_3$, apte à protéger la troisième couche d'isolant 133 lors d'une attaque acide telle qu'une attaque à l'acide fluorhydrique HF. La troisième couche de protection 142 peut présenter une épaisseur comprise entre 10 et 50 nm et préférentiellement égale à 25 nm.

La structure comporte, de part et d'autre de l'empilement, les premier et un deuxième bras d'isolation thermique 310, 320 comprenant respectivement la première et la deuxième piste de conduction 311, 321 pour permettre la polarisation du transistor 100. Selon la possibilité illustré, chacun du premier et du deuxième bras d'isolation thermique 310, 320 s'étend selon une direction perpendiculaire au plan d'absorption.

Le premier et le deuxième bras d'isolation thermique 310, 320 sont configurés pour maintenir à distance le transistor 100, et les éléments d'absorption 121, 125 qu'il comporte, du substrat 410 comprenant le circuit de lecture 340 tout en assurant, par la première et la deuxième piste de conduction 311, 321, la connexion électrique entre le transistor 100 et le circuit de lecture 340. De cette manière, le contact thermique entre le transistor 100 et le circuit de lecture 410 est réduit au minimum. La structure de détection 10 présente, en ce qui concerne ses éléments d'absorption, donc une inertie thermique relativement faible et voit sa sensibilité préservée.

On notera que, selon une possibilité préférée de l'invention non illustré sur les figures, chacun du premier et du deuxième bras d'isolation comporte à un ruban d'isolation présentent une forme en serpentin s'étendant parallèlement au plan d'absorption

Chacun des premier et deuxième bras d'isolation thermique 310, 320 comporte une première portion, en contact avec respectivement l'électrode de grille 120 et le contact ohmique 125. La première portion comporte une première couche barrière 312, par exemple en nitrure de titane TiN ou une bicouche titane/nitrure de titane Ti/TiN, adatée pour limiter les risques de diffusion de cuivre dans les première et deuxième zones 111, 112 et un corps en cuivre recouvert par ladite première couche barrière 312.

Chacun des premier et deuxième bras d'isolation thermique 310, 320 comporte en outre une deuxième portion 310A, 320A prolongeant la première portion dudit bras d'isolation thermique 310, 320 en direction du substrat. La deuxième portion 310A, 320B, dans ce premier mode de réalisation, est réalisée en cuivre.

Bien entendu, en variante à l'invention et en conformité avec l'enseignement du document WO2018055276 A1, le premier et le deuxième bras d'isolation thermique 310, 320 peuvent présenter une configuration autre telle que par exemple celle décrite dans ledit document.

Ainsi, selon une possibilité préférentielle de l'invention, non figurée, chacun du premier et du deuxième bras d'isolation peut comprendre un ruban d'isolation respectif. Selon cette possibilité, chaque ruban d'isolation est configuré avec une longueur optimisé sans empiètement sur la cavité quart-d'onde 350, ledit ruban d'isolation présentant une première extrémité en contact avec une partie dudit bras d'isolation connectant le transistor 100 et une deuxième extrémité connectant le circuit de commandé 200. Chaque ruban d'isolation s'étend selon un plan d'isolation parallèle au plan d'absorption et présente une forme apte à fournir une longueur optimisée ceci afin d'optimiser l'isolation thermique du transistor 100 vis-à-vis du substrat 201. Ainsi par exemple, chaque ruban d'isolation peut présenter une forme en zigzag ou encore en spirale. Chaque ruban d'isolation comprend chacun : une piste centrale métallique, par exemple, en nitrure de titane TiN, et un revêtement de passivation et d'arrêt par exemple formé d'un empilement d'une couche en silicium amorphe Sia, une couche en dioxyde d'hafnium HfO2 et une couche d'alumine $Al_2O_3$. Le plan d'isolation est préférentiellement agencé entre le transistor 100 et le circuit de commande. En variante, le plan d'isolation peut être confondu avec le plan d'absorption.

Le substrat 341 comprend le circuit de lecture 340 et présente un premier et un deuxième contact du circuit de lecture 315, 316, 325, 326 et une surface de réflexion 330 agencée pour former avec le deuxième élément absorbant 125 une cavité quart-d'onde 350 adaptée à la plage de longueur d'onde du rayonnement détecté par la structure de détection 10. La surface de réflexion 330 est préférentiellement formée dans un matériau sélectionné dans le groupe comportant l'aluminium Al, le cuivre Cu, l'or Au, le titane Ti, le platine Pt, le nickel Ni et leurs alliage dont notamment l'alliage de cuivre et d'aluminium. La surface de réflexion 330 présente une épaisseur comprise entre 100 nm et 1 $\mu$m, celle-ci étant préférentiellement égale à 300 nm. On notera que le substrat 410 présente également une quatrième couche isolante 345 recouvrant une première face du substrat et s'interposant entre le substrat et la troisième couche isolante.

De manière identique aux deuxième et troisième couches conductrices 122, 125, en raison du procédé de fabrication préféré de l'invention, dans ce premier mode de réalisation, la surface de réflexion 330 est revêtue, sur sa face qui est opposée au substrat, d'une quatrième couche de protection, telle qu'une couche en nitrure d'aluminium AlN, de dioxyde d'hafnium HfO2 ou de saphir $Al_2O_3$, apte à protéger la surface de réflexion 330 lors d'une attaque acide telle qu'une attaque à l'acide fluorhydrique HF. La quatrième couche de protection 351 présente une épaisseur comprise entre 10 et 50 nm et préférentiellement égale à 25 nm.

Une telle structure de détection 10 peut être fabriquée au moyen d'un procédé de fabrication présentant trois phases différentes :

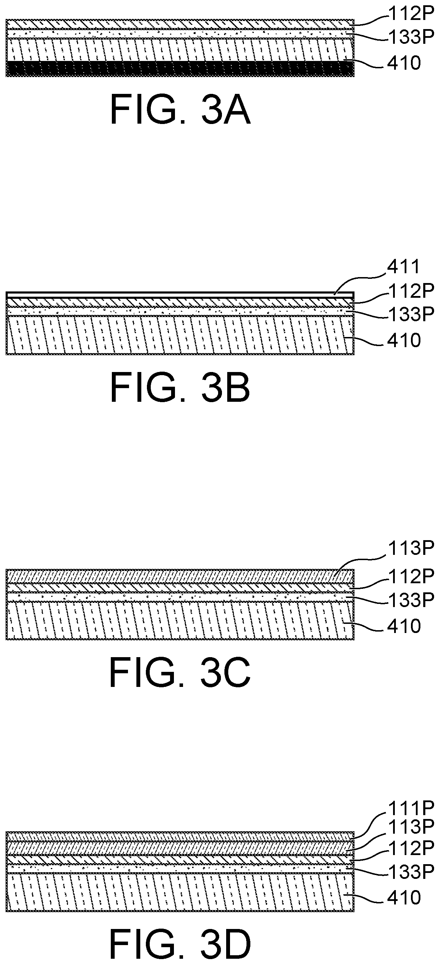

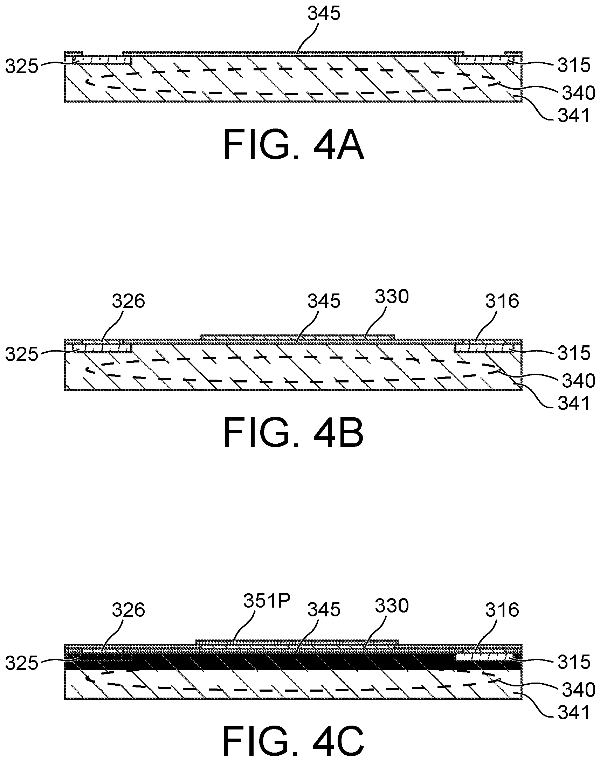

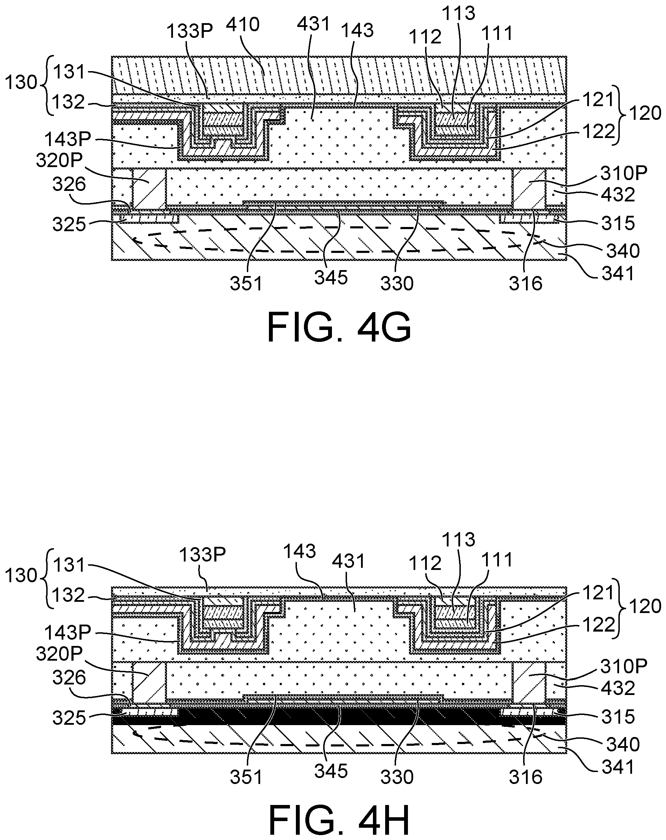

- une première phase de fabrication des principales parties du transistor 100, les étapes correspondant à cette première phase étant illustrées sur les figures 3A à 3L,
- une deuxième phase de fabrication du substrat comportant le circuit de lecture 340, les étapes correspondant à la deuxième phase étant illustrées sur les figures 4A à 4F,
- une troisième phase d'assemblage du substrat 341 comportant le circuit de lecture et du transistor 100 et de finalisation de la structure de détection 10, les étapes correspondant à la troisième phase étant illustrées sur les figures 4G à 4S.

Ainsi, comme illustré sur les figures 3A à L, la première phase du procédé de fabrication comprend les étapes suivantes :

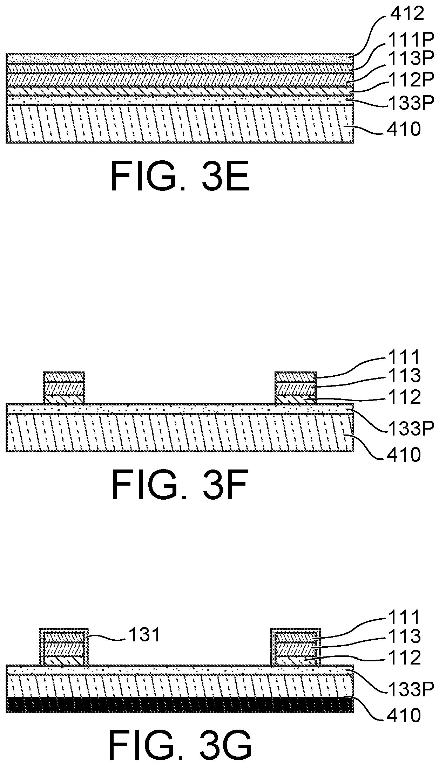

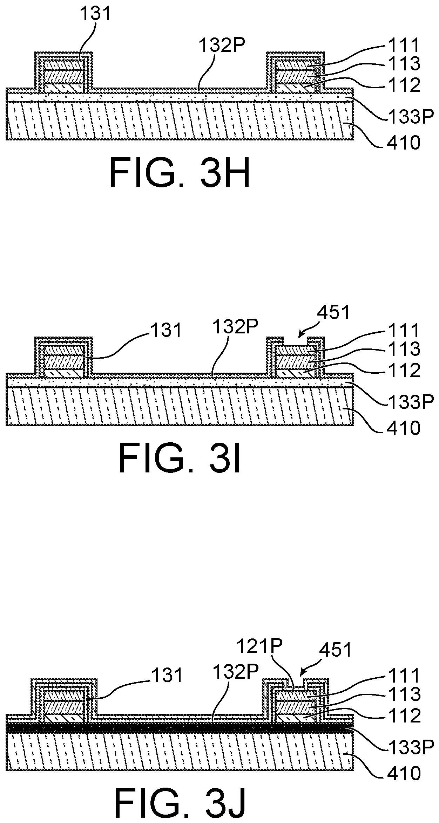

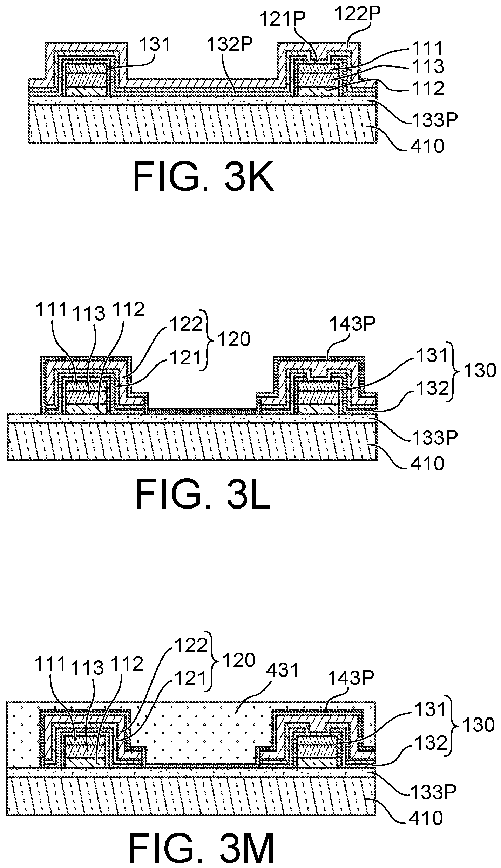

- fourniture d'un premier substrat 410 comprenant une couche semiconductrice sur isolant, ladite couche formant la deuxième couche 112P selon l'invention et l'isolant étant formé par une troisième couche isolante 133P, tel qu'un substrat silicium sur isolant 133 plus connu sous le sigle anglais SOI, comme illustré sur la figure 3A,
- oxydation partielle de la deuxième couche 112P pour former une couche d'oxyde 411 et implantation, ceci au travers de ladite couche d'oxyde 411, en éléments dopants correspondant au premier type de conductivité de la deuxième couche 112P de manière à fournir la deuxième couche 112P de la structure de détection 10, l'élément dopant étant du phosphore P dans le cas où le premier type de conductivité correspond à un dopage P, et du bore B dans le cas où le premier type de conductivité correspond à un dopage N, comme illustré sur la figure 3B,
- retrait de la couche d'oxyde 411 formée lors de l'oxydation de la deuxième couche 112P,
- dépôt par épitaxie d'une troisième couche 113P de matériau semiconducteur en contact avec la deuxième couche 112P, la troisième couche 113P étant du deuxième type de conductivité opposé au premier type de conductivité avec une concentration en porteurs majoritaires inférieure à celle de la deuxième couche 112P, ceci de manière à fournir la troisième couche 113P de la structure de détection 10, comme illustré sur la figure 3C,
- dépôt d'une première couche 111P de matériau semiconducteur en contact avec la troisième couche 113P, comme illustré sur la figure 3D, la première couche 111P étant du premier type de conductivité, soit par un dopage *in situ* lors du dépôt, soit par une implantation *post* dépôt, ceci de manière à fournir la première couche 111P de la structure de détection 10, comme illustré sur la figure 3D,
- recuit thermique afin d'activer les éléments dopants de la première et deuxième couche 111P, 112P et, le cas échéant, de la troisième couche 113P, comme illustré sur la figure 3E, on notera que sur la figure 3E, la première couche 113P est revêtue d'une couche d'oxyde d'implantation 412 conformément à la possibilité selon laquelle le dopage de la première couche 111P est fourni par une implantation poste dépôt,
- gravure localisée de l'empilement formé par les première, troisième et deuxième couches 111P, 113P, 112P afin de fournir, conformément au présent mode de réalisation de l'invention, un empilement s'étendant le long d'une ligne fermée, les première, deuxième et troisième zones 111, 112, 113 étant ainsi formées, comme illustré sur la figure 3F et conformément à la figure 2B,
- formation d'un oxyde thermique en contact avec les parois latérales et la face comportant la première zone de l'empilement des première, deuxième et troisième zone 111, 112, 113, ceci de manière à former la première couche isolante 131P, comme illustré sur la figure 3G,
- dépôt d'un matériau diélectrique présentant un coefficient diélectrique supérieur à celui du dioxyde de silicium $SiO_2$ en contact avec la première couche isolante 131P ceci de manière à former la deuxième couche isolante 132P, lesdites première et deuxième couches isolantes 131P, 132P formant notamment l'oxyde de grille 130, comme illustré sur la figure 3H,
- aménagement d'au moins une ouverture 451 dans la première et la deuxième couche isolante 131P, 132P pour libérer une zone de la première zone 111 et permettre de la contacter électriquement, comme illustré sur la figure 3I,
- implantation optionnelle d'élément dopant du premier type de conductivité dans la première zone 111 au travers de l'ouverture 451 ceci afin de favoriser la prise de contact sur ladite première zone 111,
- dans le cas où la première zone est en silicium, opération optionnelle de siliciuration au niveau de l'ouverture 451 afin de former une couche dans un siliciure sélectionné parmi le siliciure de nickel NiSi, le siliciure de titane TiSi, le siliciure de cobalt CoSi et le siliciure de platine PtSi,
- dépôt d'un premier matériau conducteur en contact de la deuxième couche isolante 132P et de la première zone 111 au niveau de l'au moins une ouverture 451 aménagée dans la première et la deuxième couche isolante 131A, 131B, ceci de manière à former la première couche conductrice 121P, ledit premier matériau conducteur étant pour le présent mode de réalisation du nitrure de titane TiN avec une épaisseur comprise entre 5 et 15 nm, préférentiellement égale à 10 nm, comme illustré sur la figure 3J,
- dépôt d'un deuxième matériau conducteur en contact de la première couche conductrice ceci de manière à former la deuxième couche conductrice 122P, ledit deuxième matériau conducteur étant pour le présent mode de réalisation du silicium polycristalin pSi du premier type de conductivité déposé par un dépôt chimique en phase vapeur avec une épaisseur comprise entre 10 et 100 nm, préférentiellement égale à 50 nm, comme illustré sur le figure 3K,

- dépôt d'une première couche de protection 143P telle qu'une couche en nitrure d'aluminium AIN, de dioxyde d'hafnium HfO2 ou de saphir Al2O3, apte à protéger lesdites couche conductrice lors d'une attaque acide telle qu'une attaque à l'acide fluorhydrique HF, ladite couche de protection présentant une épaisseur comprise entre 10 et 50 nm et préférentiellement égale à 25 nm, comme illustré sur la figure 3L,

- dépôt d'un premier matériau sacrificiel, telle que du dioxyde de silicium $SiO_2$ en contact avec la couche de protection et étape de planarisation dudit matériau sacrificiel pour supprimer l'excès de matériau sacrificiel ceci de manière à encapsuler l'ensemble première, deuxième et troisième zone/ première et deuxième couche isolante/ première et deuxième couche conductrice/ couche de protection, les principales parties du transistor 100 ayant été ainsi formées et un premier ensemble à assemblé comprenant le premier substrat étant formé, comme illustré sur la figure 3M.

La deuxième phase du procédé de fabrication selon l'invention peut être mise en oeuvre avant, concomitamment, ou après la première phase décrite ci-dessus. La deuxième phase comprend les étapes suivantes :

- fourniture d'un deuxième substrat 341, le deuxième substrat 341 comprenant un circuit de lecture 340 et, sur une première surface du deuxième substrat 341 présentant un premier et un deuxième contact 325, 321 du circuit de lecture destinés à connecter respectivement à l'électrode de grille/première zone 111 et la deuxième zone 112, et une quatrième couche isolante 345, préférentiellement en dioxyde de silicium $SiO_2$, revêtant la partie de la première surface du deuxième substrat 340 en dehors du premier et du deuxième contact 325, 315 du circuit de lecture 341, ladite quatrième couche isolante recouvrant également la périphérie du premier et du deuxième contact 325, 315 du circuit de lecture 341, comme illustré sur la figure 4A,

- dépôt localisé d'un matériau réflecteur et conducteur en contact avec le premier et le deuxième contact 325, 315 et sur une partie de la quatrième couche isolante 345 pour former un premier et un deuxième plot de contact 326, 316 et la surface de réflexion 330, le matériau réflecteur et conducteur, dans ce mode de réalisation de l'invention, étant sélectionné dans le groupe comportant l'aluminium Al, le cuivre Cu, l'or Au, le titane Ti, le platine Pt, le nickel Ni et leurs alliage dont notamment l'alliage de cuivre et d'aluminium avec une épaisseur comprise entre 100 nm et 1 $\mu$m, celle-ci étant préférentiellement égale à 300 nm, comme illustré sur la figure 4B,

dépôt d'une quatrième couche de protection 351 sur le premier substrat 340 en contact avec la surface de réflexion 330, les premier et deuxième plots de contact 326, 316 et la partie de la quatrième couche isolante 345 qui est libre de matériau réflecteur et conducteur, la quatrième couche de protection 351 étant préférentiellement choisie parmi une couche en nitrure d'aluminium AIN, de dioxyde d'hafnium HfO2 ou de saphir Al2O3, apte à protéger lesdites couche conductrice lors d'une attaque acide telle qu'une attaque à l'acide fluorhydrique HF, ladite quatrième couche de protection 345 présentant une épaisseur comprise entre 10 et 50 nm et préférentiellement égale à 25 nm, comme illustré sur la figure 4C,

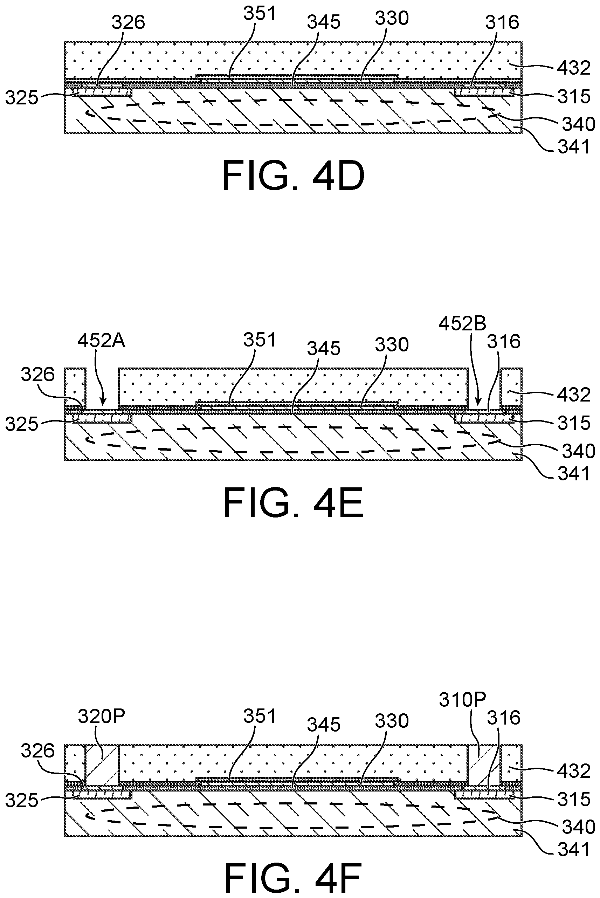

- dépôt d'un deuxième matériau sacrificiel 432, telle que du dioxyde de silicium $SiO_2$ en contact avec la quatrième couche de protection 351 et étape de planarisation dudit matériau sacrificiel pour supprimer l'excès du deuxième matériau sacrificiel et fournir une couche du deuxième matériau sacrificiel comprise entre 1,3 et 2,5 $\mu$m, comme illustré sur la figure 4D,

formation d'une première et d'une deuxième percée 452A, 452B par gravure localisée de la couche du deuxième matériau sacrificiel 432 et de la quatrième couche de protection 451 pour libérer le premier et le deuxième plot contact 326, 316 du circuit de lecture 341, comme illustré sur la figure 4E,

- remplissage de la première et la deuxième percée 452A, 452B par un matériau métallique pour former une première partie 320P, 310P de respectivement le premier et le deuxième bras d'isolation 320, 310, un deuxième ensemble à assembler comprenant le deuxième substrat 340, le matériau réflecteur et conducteur, le deuxième matériau sacrificiel 432 et les premières parties 310P, 320P du premier et du deuxième bras d'isolation thermique 310, 320. étant ainsi formé, comme illustré sur la figure 4F,

- collage du premier et du deuxième ensemble par leur face comprenant respectivement le premier et le deuxième matériau sacrificiel 431, 432, comme illustré sur la figure 4G,

- suppression du premier substrat 410, comme illustré sur la figure 4H,

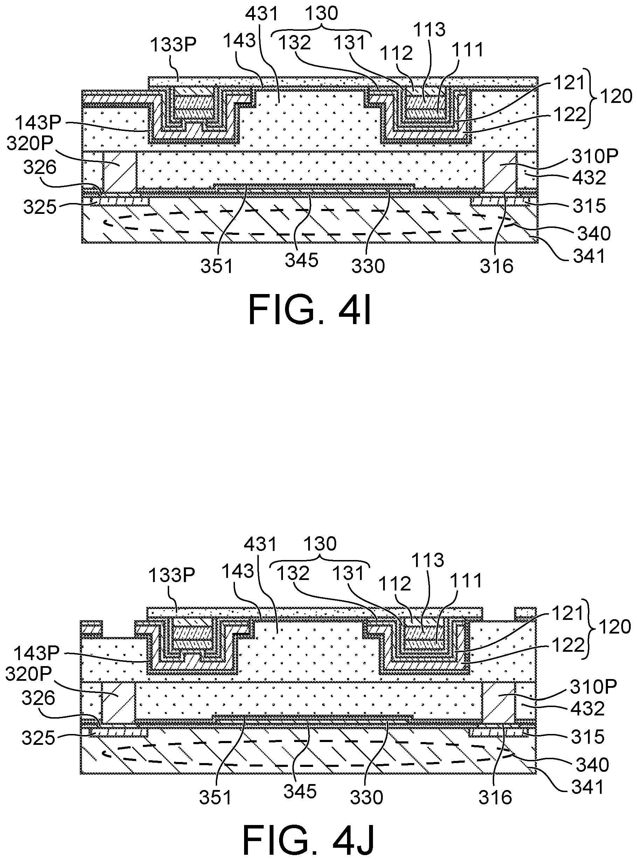

- gravure localisée de la troisième couche d'isolant 133P révélé lors de la suppression du premier substrat 410 et de la première et la deuxième couche d'isolant 131, 132, les partie des première, deuxième et troisième couche d'isolant 131P, 132P, 133P supprimées lors de ladite gravure étant les parties en regard de la première partie du deuxième bras d'isolation thermique 320, comme illustré sur la figure 4I,

- gravure localisée, d'une part, une partie de la première et la deuxième couche conductrice 121P, 122P et de la première couche de protection 143 en regard de la première partie du deuxième bras d'isolation thermique 320 et d'autre part, une partie de la troisième couche d'isolant 133 et de la première couche de protection 143 en regard la première partie du premier bras d'isolation 310, comme illustré sur la figure 4J,

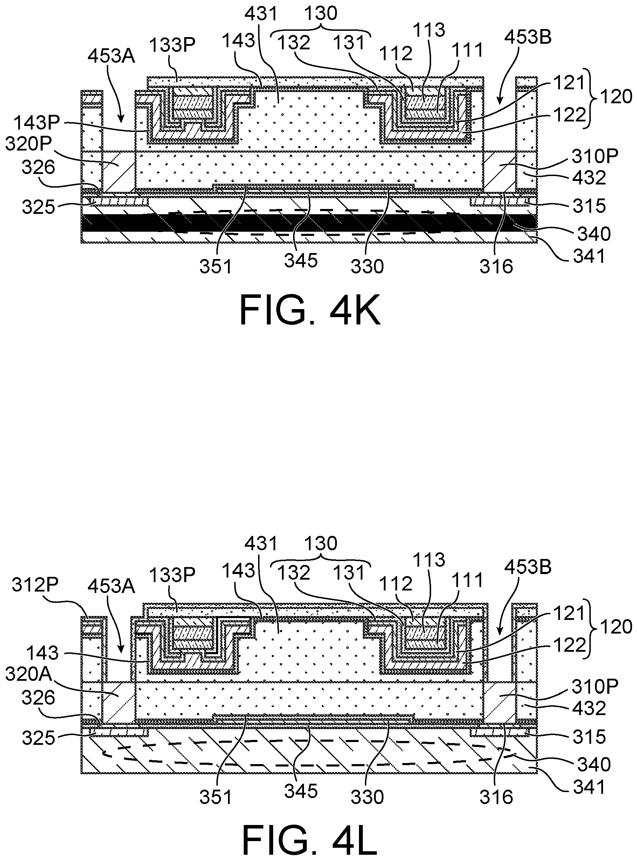

- prolongation, par gravure sélective, desdites parties gravées localement lors de l'étape précédente afin d'atteindre le premier et le deuxième bras d'isolation et former une troisième et une quatrième percée 453A, 453B, comme illustré sur la figure 4K,

- dépôt dans les troisième et quatrième percées 453A, 453B et sur la surface de la couche d'isolant d'une première couche barrière 312P, par exemple en nitrure de titane TiN ou une bicouche titane/nitrure de titane Ti/TiN, ladite couche barrière présentant une épaisseur comprise entre 5 et 50 nm et préférentiellement égale à 25 nm, comme illustré sur la figure 4L,

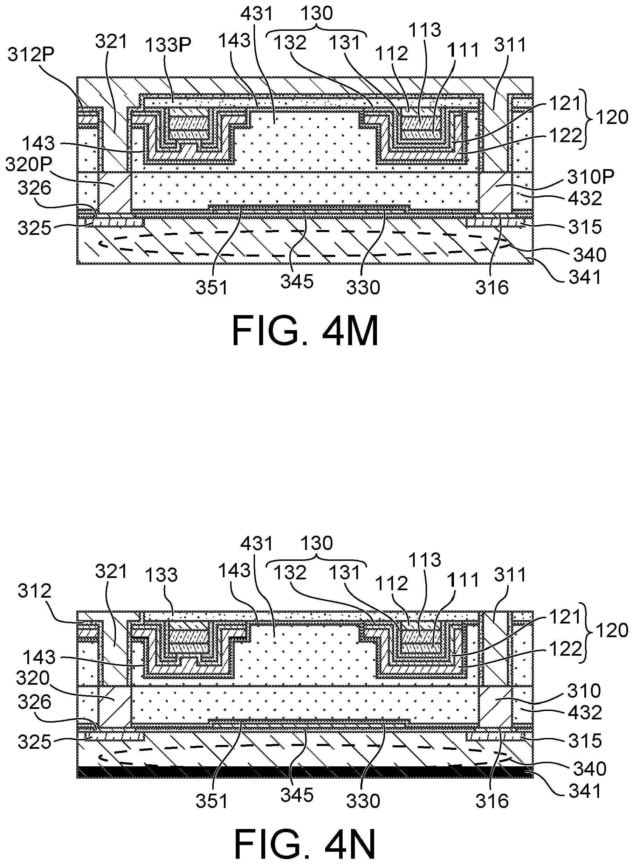

- remplissage des troisième et quatrième percées 453A, 453B par le un deuxième matériau métallique pour former une deuxième partie de respectivement le premier et le deuxième bras d'isolation 310, 320 ceci en contact de respectivement la première partie du premier et du deuxième bras d'isolation 310, 320, ceci de manière à former le premier et le deuxième bras d'isolation 310, 320et la première et la deuxième piste de conduction 311, 321 comme illustré sur la figure 4M,

- étape de polissage afin de supprimer le surplus de deuxième matériau métallique et la partie de la première couche barrière 312P en contact avec la surface de la troisième couche d'isolant 133P, comme illustré sur la figure 4N,

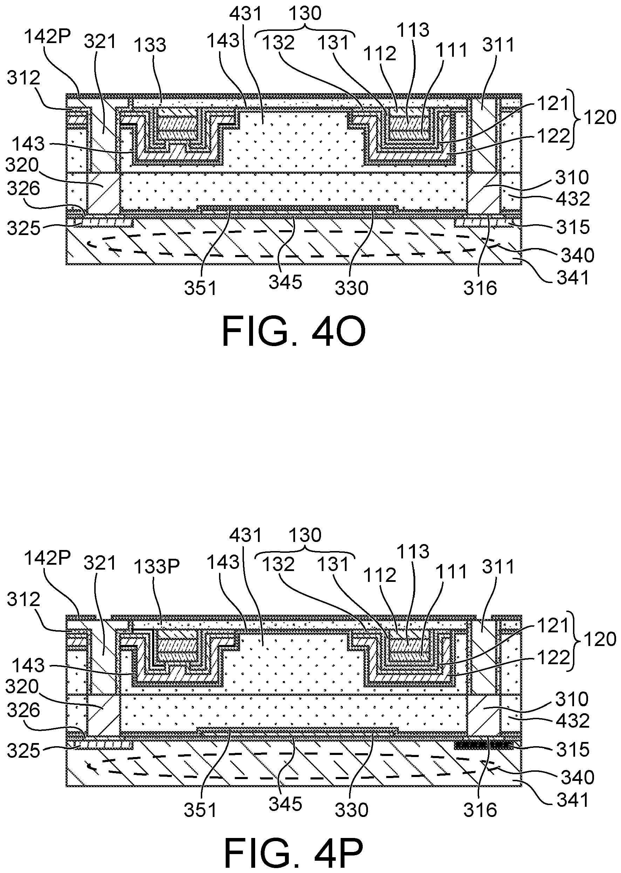

- dépôt d'une deuxième couche de protection 142P s en contact avec la troisième couche d'isolant 133P et des portions des deuxièmes parties des premier et deuxième bras d'isolation 310, 320 qui affleures ladite troisième couche d'isolant 133P, la deuxième couche de protection 142P étant préférentiellement choisie parmi une couche en nitrure d'aluminium AlN, de dioxyde d'hafnium HfO2 ou de saphir Al2O3, apte à protéger ladite troisième couche d'isolant 133P et lesdites portions des deuxième parties des premier et deuxième bras d'isolation 310, 320 lors d'une attaque acide telle qu'une attaque à l'acide fluorhydrique HF, ladite deuxième couche de protection 142P présentant une épaisseur comprise entre 10 et 50 nm et préférentiellement égale à 25 nm, comme illustré sur la figure 4O,

- gravure localisée de la deuxième couche de protection 142P en regard du premier et deuxième bras d'isolation 310, 320, comme illustré sur la figure 4P,

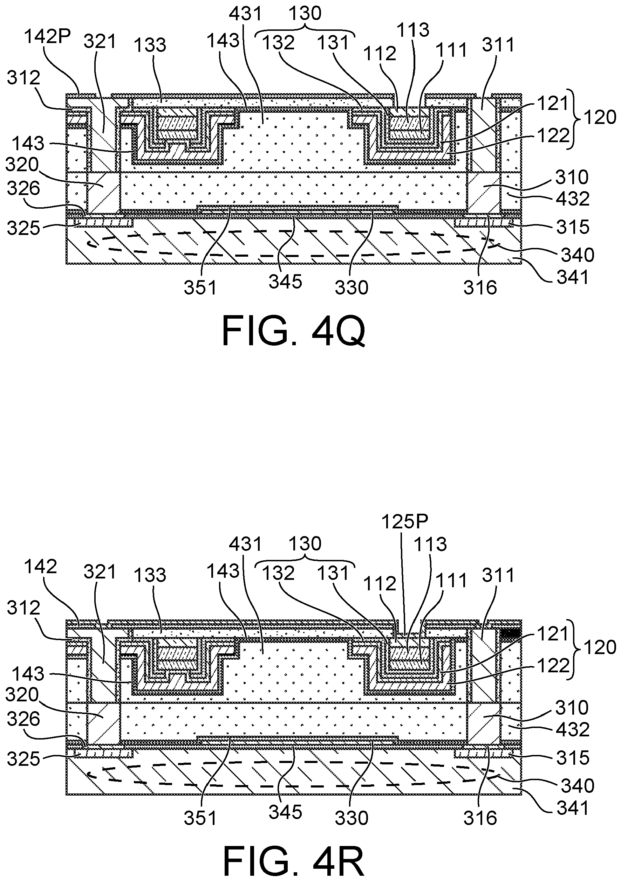

- gravure localisée de la deuxième couche de protection 142P et de la troisième couche d'isolant 133P en regard de la deuxième zone 112, la troisième couche de protection 142 et la troisième couche d'isolant 133 étant ainsi formées, comme illustré sur la figure 4Q,

- dépôt d'un troisième matériau conducteur 125P en contact avec la troisième couche de protection 142 et les parties de la deuxième zone 112, du premier et du deuxième bras libres de la deuxième couche de protection pour former un troisième couche conductrice 125P, le troisième couche conductrice 125P étant en contact avec la deuxième zone 112 et avec chacune de la première et de la deuxième piste conductrice 311, 321, comme illustré sur la figure 4R,

- gravure localisée de la troisième couche conductrice 125P afin d'isoler électriquement la première piste de conduction 320 de la deuxième piste de conduction 311, une partie de la troisième couche de protection 142 étant ainsi libérée et la troisième couche conductrice 125 étant ainsi formée,

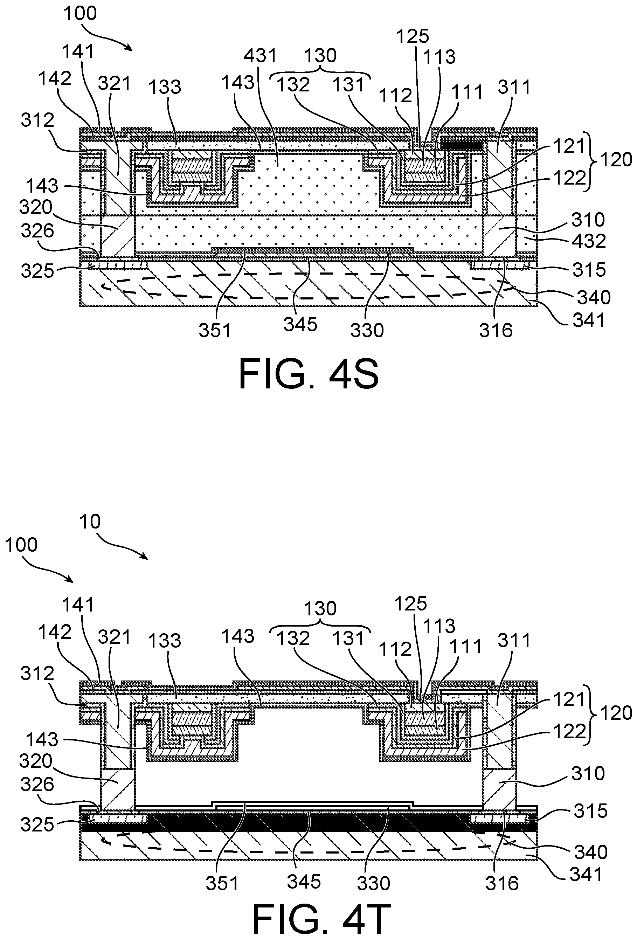

- dépôt d'une première couche de protection 141 en contact de la troisième couche conductrice 125 et de la partie de la troisième couche de protection libre de la couche du troisième matériau conducteur, comme illustré sur figure 4S,

- attaque sélective du premier et du deuxième matériau sacrificiel 431, 432 afin de libérer les premier et deuxième bras d'isolation 310, 320 et ainsi former la structure de détection 10, comme illustré sur la figure 4T.

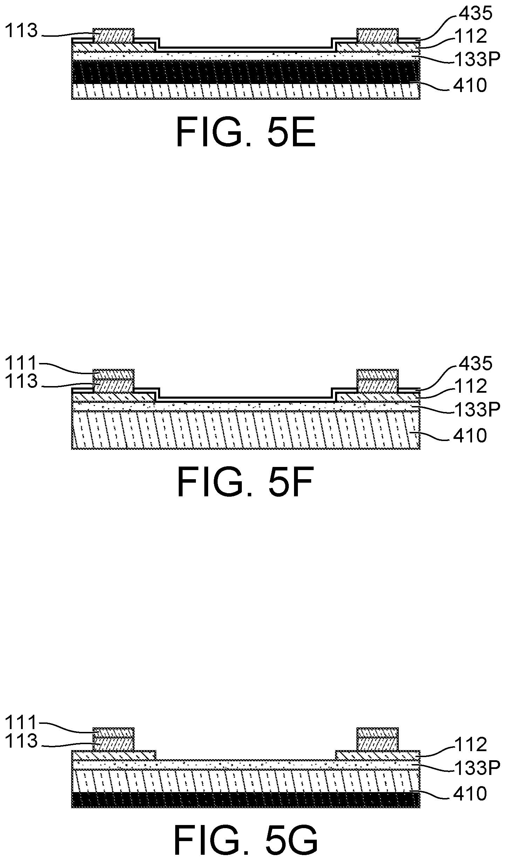

Selon une autre possibilité de l'invention, les première à la troisième zones 111, 112, 113 peuvent ne pas présenter des dimensions latérale identique, la deuxième zone 112 pouvant, par exemple, présenter une largeur plus important que celle de la première et la troisième zone 111, 113 comme illustré sur la figure 5G.

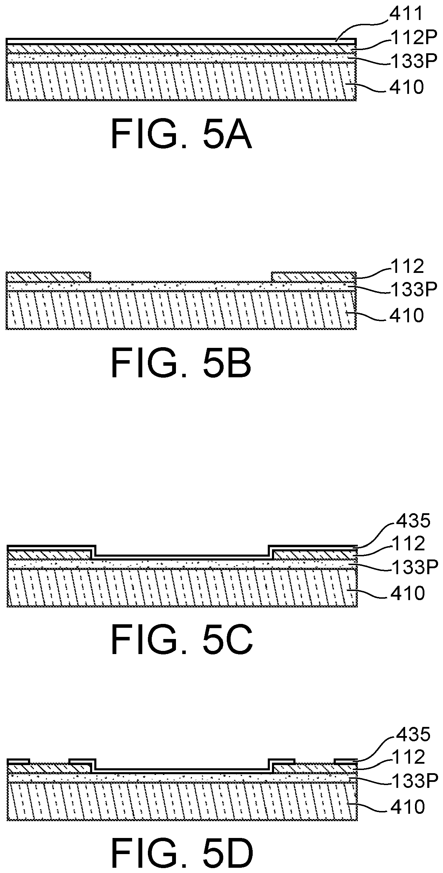

Si une structure de détection selon cette autre possibilité de l'invention ne diffère que par les dimensions latérales de ladite deuxième zone 112, le procédé de fabrication d'une structure de détection 113 cette autre possibilité se différencie en ce que lors de la première phase de fabrication des principales parties du transistor 100, les étapes comprises entre l'étape d'oxydation pour former une couche d'oxyde 411 de la figure 3B et implantation et l'étape de gravure localisée de l'empilement formé de la figure 3F sont remplacée par les étapes suivantes illustrées sur les figures 5A à 5G :

- oxydation pour former une couche d'oxyde 411 et implantation, ceci au travers de ladite couche d'oxyde 411, en éléments dopants correspondant au premier type de conductivité de la deuxième couche 112P de manière à fournir la deuxième couche 112P de la structure de détection 10, l'élément dopant étant du phosphore P dans le cas où le premier type de conductivité correspond à un dopage P, et du bore B dans le cas où le premier type de conductivité correspond à un dopage N, d'une manière identique à l'étape de la figure 3B et comme illustré sur la figure 5A,

- gravure localisée de la deuxième couche 112P pour former la deuxième zone 112, comme illustré sur la figure 5B,
- dépôt d'une couche 435 de matériau choisi parmi un oxyde tel qu'un dioxyde de silicium, ou un nitrure, tel qu'un nitrure de silicium SiN, en contact de la deuxième couche 112P et de la troisième couche d'isolant 133P, ladite couche 435 présentant une épaisseur comprise entre 10 et 100 nm, comme illustré sur la figure 5C,
- gravure localisée de la couche 435 de manière à libérer une partie de la deuxième couche 112P correspondant à la troisième zone 113, comme illustré sur la figure 5D,
- dépôt sélectif de la troisième couche 113P en contact avec la partie de la deuxième couche 112P libre de couche 435 de manière à former la troisième zone 113, la troisième couche 113P étant du deuxième type de conductivité opposé au premier type de conductivité avec une concentration en porteurs majoritaires inférieure à celle de la deuxième couche 112P, ceci de manière à fournir la troisième couche 113P de la structure de détection 10, comme illustré sur la figure 5E,
- dépôt sélectif de la première couche 111P de matériau semiconducteur en contact avec la troisième couche 113P, la première couche 111P étant du premier type de conductivité, soit par un dopage *in situ* lors du dépôt, soit par une implantation *post* dépôt, ceci de manière à fournir la première couche 111P de la structure de détection 10, comme illustré sur la figure 5F,
- suppression de la couche 435, comme illustré sur la figure 5G.

Selon un troisième mode de réalisation de l'invention, non illustré, la première couche conductrice 121 peut s'étendre le long de la zone de détection et définir, pour la partie de la première couche conductrice 121 s'étendant le long de la zone de détection, le plan d'absorption. On notera que par « s'étendant le long de la zone de détection », il doit être entendu que la partie de la première couche conductrice s'étend parallèlement à ladite zone de détection à proximité de cette dernière.

Ainsi, une structure de détection 1 selon ce troisième mode de réalisation se différencie d'une structure de détection 1 selon le premier mode de réalisation en ce que :

- c'est la première couche conductrice 121 qui définit, pour au moins sa partie s'étendant le long de la zone de détection, le plan d'absorption, la cavité quart-d'onde 350 étant donc formée entre la première couche semiconductrice 121 et la surface de réflexion 330,

- la troisième couche conductrice 125 ne s'étend pas le long de la zone de détection.

Un procédé de fabrication d'une structure de détection 1 selon ce troisième se différencie d'un procédé de fabrication d'une structure de détection uniquement en ce que lors des étapes de gravure localisée de la troisième couche conductrice 125P et de de la première couche conductrice 121P, la partie s'étendant le long de la zone de détection est conservée pour la première couche conductrice 121P et gravée pour la troisième couche conductrice 125P.

Selon une variante de ce troisième mode de réalisation, la troisième couche conductrice 125 peut s'étendre également le long de la zone de détection. Selon cette variante, l'une de la première et de la deuxième zone conductrice défini le plan d'absorption, l'autre fournissant une absorption supplémentaire à la structure de détection selon le même principe décrit dans le premier mode de réalisation pour lequel la deuxième couche conductrice 121 de l'électrode grille de fourni un élément absorbant complémentaire à l'élément absorbant formé par la troisième couche conductrice 125.

Bien entendu, les premier, deuxième et troisième modes de réalisation décrits ci-dessus sont fournis qu'à titre d'exemple et illustre une configuration de l'invention correspondant à une application particulière de celle-ci. Ainsi, par exemple, si dans ces deux modes de réalisation, la première couche conductrice 121 est réalisée dans un métal « milieu de gap », il est envisageable, sans que l'on sorte du cadre de l'invention, que la première couche conductrice 121 peut être formée dans un autre matériau conducteur qu'un métal « milieu de gap ».

## Revendications

1. Structure de détection (10) de type bolomètre pour la détection d'un rayonnement électromagnétique, la structure de détection (10) comportant :

   - au moins un élément absorbant (121, 125) configuré pour absorber le rayonnement électromagnétique, ledit élément absorbant (121, 125) définissant un plan d'absorption,
   - un transistor (100) du type MOS-FET associé avec l'élément absorbant pour détecter l'élévation de température dudit élément absorbant lors de l'absorption du rayonnement électromagnétique par ce dernier, le transistor comportant :

     • au moins une première et au moins une deuxième zone (111, 112) d'un premier type de conductivité,
     • au moins une troisième zone (113) séparant l'une de l'autre la première et la deuxième zone (111, 112), la troisième zone (113)

étant d'un deuxième type de conductivité opposé au premier type de conductivité et présentant un concentration en porteurs majoritaires inférieure à celle de la première et de la deuxième zone (111, 112),
• une électrode de grille (120) agencée pour polariser la troisième zone (113),

la structure de détection (10) **étant caractérisée en ce que** la première zone (111), la troisième zone (113) et la deuxième zone (112) sont formées par respectivement par une première, une troisième et une deuxième couche, chacune de la première couche, de la deuxième couche, et de la troisième couche s'étendant parallèlement au plan d'absorption, les première, troisième et deuxième couches se succédant selon une direction perpendiculaire audit plan d'absorption, chacune desdites première, deuxième et troisième zones présentant, selon l'épaisseur de la couche correspondante, au moins une paroi latérale,
et **en ce que** l'électrode de grille recouvre la troisième zone le long d'au moins une paroi latérale de ladite troisième zone.

2. Structure de détection (1) selon la revendication 1, dans laquelle la troisième zone (113) présente au moins deux parois latérales, l'électrode de grille recouvrant la troisième zone le long d'au moins deux parois latérales de ladite troisième zone qui sont opposées l'une à l'autre.

3. Structure de détection (1) selon la revendication 1 ou 2 dans lequel l'élément absorbant comprend une portion d'absorption s'étendant au-delà d'un empilement formé par les première, troisième et deuxième zones (111, 113, 112).

4. Structure de détection (1) selon la revendication 3, dans lequel l'empilement formé par les première, troisième et deuxième zones (111, 113, 112) entoure au moins en partie une zone la structure de détection (1) qui est dite zone de détection, la portion d'absorption s'étendant au moins en partie le long de ladite zone de détection.

5. Structure de détection (1) selon l'une quelconque des revendications 1 à 4, dans lequel l'électrode grille (120) comprend l'élément absorbant (121).

6. Structure de détection (1) selon la revendication 5 prise en combinaison avec la revendication 3 ou 4, dans lequel l'élément absorbant (121) de l'au moins un élément absorbant comprend au moins une couche réalisée dans un métal « milieu de gap » pour la troisième zone (113).

7. Structure de détection (1) selon l'une quelconque des revendications 1 à 6, dans lequel le transistor (100) comporte en outre un contact métallique pour la deuxième zone (112).

8. Structure de détection (1) selon la revendication 7 prise seule ou en combinaison avec l'une quelconque des revendications 2 à 6, dans laquelle le contact métallique de la deuxième zone (112) comporte l'élément absorbant (125).

9. Structure de détection (1) selon l'une quelconque des revendications 1 à 8, dans lequel l'élément absorbant (121,125) comprend une couche conductrice supportée par au moins une couche isolante (133, 132), le métal de la couche métallique et les épaisseurs de ladite couche métallique et de l'au moins une couche isolante (133, 132) la supportant étant choisies de manière à respecter les inégalités suivantes :

$$150\Omega \le \frac{\rho}{Ep} \le 700\ \Omega$$

avec $\rho$ la résistivité équivalente desdites couches et Ep la somme des épaisseurs desdites couches.

10. Structure de détection (1) selon l'une quelconque des revendications 1 à 9, dans lequel l'électrode de grille (120) recouvre également la première zone et forme un contact métallique de ladite première zone (111).

11. Procédé de fabrication d'une structure de détection (10) de type bolomètre pour la détection d'un rayonnement électromagnétique, le procédé de fabrication comprenant les étapes suivantes :

- fourniture d'une deuxième zone (112) d'un premier type de conductivité, ladite deuxième zone (112) s'étendant selon un plan d'absorption, la deuxième zone étant formée par une deuxième couche,
- formation d'une troisième zone (113) en contact avec la deuxième zone (112), ladite troisième zone (113) étant d'un deuxième type de conductivité opposé au premier type de conductivité avec une concentration en porteurs majoritaires inférieure à celle de la deuxième zone (112), la troisième zone (113) étant formée par une troisième couche,
- formation d'une première zone (111) en contact avec la troisième couche (113A), la première zone (111) étant du premier type de conductivité avec une concentration en porteurs majoritaires supérieure à celle de la troisième zone (113) et étant formée par une première couche, de telle manière que chacune de la première couche , de la deuxième couche , et de la troisième couche s'étendent parallèlement à un plan d'absorption et que les première, troisième et deuxième couches se succèdent selon une direction perpendiculaire audit plan d'absorption, chacune desdites première, deuxième et troisième zones (111, 112, 113) présentant, selon l'épaisseur de la couche correspondante, au moins une paroi latérale,

- formation d'une électrode de grille (120) recouvrant la troisième zone le long d'au moins une paroi latérale de ladite troisième zone ceci de manière à former un transistor (100) du type MOS-FET comprenant les première, deuxième et troisième zone (111, 112, 113) et l'électrode de grille (120), l'électrode de grille (120) étant agencée pour polariser la troisième zone (113),

le procédé de fabrication comprenant en outre la formation d'un élément absorbant (121, 125) associé au transistor (100) de telle manière que le transistor (100) soit apte à détecter l'élévation de température dudit élément absorbant lors de l'absorption du rayonnement électromagnétique, ledit élément absorbant (121, 125) définissant le plan d'absorption.

**12.** Procédé de fabrication selon la revendication 11, dans lequel les étapes de fourniture et de formation des première, deuxième et troisième zones (111, 112, 113) sont concomitantes, ladite fourniture et lesdites formations étant réalisées par une gravure d'un empilement comprenant une deuxième, une troisième et une première couche (111P, 112P, 113P).

**13.** Procédé de fabrication selon la revendication 11, dans lequel la deuxième zone (112) est fournie préalablement à la formation des troisième et première zones (113, 111), la troisième zone étant formée par un dépôt sélectif sur au moins une portion de la deuxième zone (112) et la première zone (111) étant formée par un dépôt sélectif sur au moins une portion de la troisième zone (113).

**Patentansprüche**

**1.** Detektionsstruktur (10) vom Typ Bolometer zur Detektion elektromagnetischer Strahlung, wobei die Detektionsstruktur (10) beinhaltet:

- Mindestens ein absorbierendes Element (121, 125), das konfiguriert ist, um die elektromagnetische Strahlung zu absorbieren, wobei das absorbierende Element (121, 125) eine Absorptionsebene definiert,
- einen Transistor (100) vom Typ MOS-FET, der mit dem absorbierenden Element assoziiert ist, um den Temperaturanstieg des absorbierenden Elements während der Absorption elektromagnetischer Strahlung durch dieses zu detektieren, wobei der Transistor beinhaltet:

• mindestens eine erste und mindestens eine zweite Zone (111, 112) eines ersten Leitfähigkeitstyps,
• mindestens eine dritte Zone (113), die die erste und die zweite Zone (111, 112) voneinander trennt, wobei die dritte Zone (113) einen zweiten Leitfähigkeitstyp hat, der dem ersten Leitfähigkeitstyp entgegengesetzt ist, und eine geringere Konzentration an Majoritätsträgern aufweist als die erste und die zweite Zone (111, 112),
• eine Gateelektrode (120), die eingerichtet ist, um die dritte Zone (113) zu polarisieren,

wobei die Detektionsstruktur (10) **dadurch gekennzeichnet ist, dass** die erste Zone (111), die dritte Zone (113) und die zweite Zone (112) jeweils durch eine erste, dritte und zweite Schicht gebildet sind, wobei sich jede der ersten Schicht, der zweiten Schicht und der dritten Schicht parallel zur Absorptionsebene erstrecken, wobei sich die erste, dritte und zweite Schicht entlang einer Richtung perpendikular zur Absorptionsebene aufeinander folgen, wobei jede der ersten, zweiten und dritten Zonen, je nach Dicke der entsprechenden Schicht, mindestens eine Seitenwand aufweisen, und dass die Gateelektrode die dritte Zone entlang mindestens einer Seitenwand der dritten Zone bedeckt.

**2.** Detektionsstruktur (1) nach Anspruch 1, wobei die dritte Zone (113) mindestens zwei Seitenwände aufweist, wobei die Gateelektrode die dritte Zone entlang von mindestens zwei Seitenwänden der dritten Zone, die einander gegenüberliegen, bedeckt.

**3.** Detektionsstruktur (1) nach Anspruch 1 oder 2, wobei das absorbierende Element einen Absorptionsbereich umfasst, der sich über einen Stapel hinaus erstreckt, der durch die erste, dritte und zweite Zone (111, 113, 112) gebildet wird.

**4.** Detektionsstruktur (1) nach Anspruch 3, wobei der Stapel, der aus der ersten, dritten und zweiten Zone (111, 113, 112) gebildet wird, mindestens teilweise eine Zone der Detektionsstruktur (1), Detektionszone genannt, umgibt, wobei sich der Absorptionsbereich mindestens teilweise entlang der Detektionszone erstreckt.

**5.** Detektionsstruktur (1) nach einem der Ansprüche 1 bis 4, wobei die Gateelektrode (120) das absorbierende Element (121) umfasst.

6. Detektionsstruktur (1) nach Anspruch 5 in Kombination mit Anspruch 3 oder 4, wobei das absorbierende Element (121) des mindestens einen absorbierenden Elements mindestens eine Schicht umfasst, die aus einem Metall "Gap-Mitte" für die dritte Zone (113) erstellt wird.

7. Detektionsstruktur (1) nach einem der Ansprüche 1 bis 6, wobei der Transistor (100) ferner einen metallischen Kontakt für die zweite Zone (112) beinhaltet.

8. Detektionsstruktur (1) nach Anspruch 7 allein oder in Kombination mit einem der Ansprüche 2 bis 6, wobei der metallische Kontakt der zweiten Zone (112) das absorbierende Element (125) beinhaltet.

9. Detektionsstruktur (1) nach einem der Ansprüche 1 bis 8, wobei das absorbierende Element (121, 125) eine leitfähige Schicht umfasst, die von mindestens einer isolierenden Schicht (133, 132) getragen wird, wobei das Metall der Metallschicht und die Dicken der Metallschicht und der mindestens einen isolierenden Schicht (133, 132), die sie trägt, so gewählt sind, dass die folgenden Ungleichheiten eingehalten werden:

$$150\Omega \le \frac{p}{Ep} \le 700\Omega$$

wobei p der äquivalente spezifische Widerstand der Schichten ist und Ep die Summe der Dicken der Schichten ist.

10. Detektionsstruktur (1) nach einem der Ansprüche 1 bis 9, wobei die Gateelektrode (120) auch die erste Zone bedeckt und einen metallischen Kontakt der ersten Zone (111) bildet.

11. Verfahren zur Herstellung einer Detektionsstruktur (10) vom Typ Bolometer zur Detektion elektromagnetischer Strahlung, wobei das Herstellungsverfahren die folgenden Schritte umfasst:

- Bereitstellung einer zweiten Zone (112) eines ersten Leitfähigkeitstyps, wobei sich die zweite Zone (112) in einer Absorptionsebene erstreckt, wobei die zweite Zone durch eine zweite Schicht gebildet wird,
- Bildung einer dritten Zone (113) in Kontakt mit der zweiten Zone (112), wobei die dritte Zone (113) einen zweiten Leitfähigkeitstyp hat, der dem ersten Leitfähigkeitstyp entgegengesetzt ist, mit einer geringeren Konzentration an Majoritätsträgern als die zweite Zone (112), wobei die dritte Zone (113) durch eine dritte Schicht gebildet wird,
- Bildung einer ersten Zone (111) in Kontakt mit der dritten Schicht (113A), wobei die erste Zone (111) einen ersten Leitfähigkeitstyp hat mit einer höheren Konzentration an Majoritätsträgern als die dritte Zone (113), und von einer ersten Schicht derart gebildet wird, dass sich jede der ersten Schicht, der zweiten Schicht und der dritten Schicht parallel zu einer Absorptionsebene erstreckt, und sich die erste, dritte und zweite Schicht in einer Richtung perpendikular zur Absorptionsebene aufeinander folgen, wobei jede der ersten, zweiten und dritten Zonen (111, 112, 113), je nach Dicke der entsprechenden Schicht, mindestens eine Seitenwand aufweist,
- Bildung einer Gateelektrode (120), die die dritte Zone entlang mindestens einer Seitenwand der dritten Zone bedeckt, um einen Transistor (100) vom Typ MOS-FET zu bilden, der die erste, zweite und dritte Zone (111, 112, 113) und die Gateelektrode (120) umfasst, wobei die Gateelektrode (120) eingerichtet ist, um die dritte Zone (113) zu polarisieren,

wobei das Herstellungsverfahren ferner die Bildung eines absorbierenden Elements (121, 125) umfasst, das mit dem Transistor (100) derart assoziiert ist, dass der Transistor (100) geeignet ist, den Temperaturanstieg des absorbierenden Elements während der Absorption elektromagnetischer Strahlung zu detektieren, wobei das absorbierende Element (121, 125) die Absorptionsebene definiert.

12. Herstellungsverfahren nach Anspruch 11, wobei die Schritte zur Bereitstellung und Bildung der ersten, zweiten und dritten Zone (111, 112, 113) gleichzeitig erfolgen, wobei die Bereitstellung und die Bildungen durch Ätzen eines Stapels erstellt werden, der eine zweite, dritte und erste Schicht (111P, 112P, 113P) umfasst.

13. Herstellungsverfahren nach Anspruch 11, wobei die zweite Zone (112) vor der Bildung der dritten und ersten Zone (113, 111) bereitgestellt wird, wobei die dritte Zone durch selektive Abscheidung auf mindestens einem Bereich der zweiten Zone (112) gebildet wird, und die erste Zone (111) durch selektive Abscheidung auf mindestens einem Bereich der dritten Zone (113) gebildet wird.

**Claims**

1. A bolometer type detection structure (10) for detecting an electromagnetic radiation, the detection structure (10) including:

- at least one absorbent element (121, 125) configured to absorb the electromagnetic radiation, said absorbent element (121, 125) defining an absorption plane,
- a transistor (100) of the MOS-FET type associated with the absorbent element to detect the temperature rise of said absorbent element during the absorption of the electromagnetic radiation by the latter, the transistor including:

    • at least one first and at least one second zone (111, 112) of a first type of conductivity,
    • at least one third zone (113) separating the first and second zones (111, 112) from each other, the third zone (113) being of a second type of conductivity which is opposite to the first type of conductivity and having a majority carrier concentration which is lower than that of the first and second zones (111, 112),
    • a gate electrode (120) arranged to bias the third zone (113),

the detection structure (10) being **characterised in that** the first zone (111), the third zone (113) and the second zone (112) are formed respectively by first, third and second layers, each of the first layer, the second layer, and the third layer extending parallel to the absorption plane, the first, third and second layers following each other in a direction perpendicular to said absorption plane, each of said first, second and third zones having, according to the thickness of the corresponding layer, at least one lateral wall, and **in that** the gate electrode covers the third zone along at least one lateral wall of said third zone.

2. The detection structure (1) according to claim 1, wherein the third zone (113) has at least two lateral walls, the gate electrode covering the third zone along at least two lateral walls of said third zone which are opposed to each other.

3. The detection structure (1) according to claim 1 or 2 wherein the absorbent element comprises an absorption portion extending beyond a stack formed by the first, third and second zones (111, 113, 112).

4. The detection structure (1) according to claim 3, wherein the stack formed by the first, third and second zones (111, 113, 112) at least partially surrounds a zone of the detection structure (1) which is called detection zone, the absorption portion extending at least partially along said detection zone.

5. The detection structure (1) according to any one of claims 1 to 4, wherein the gate electrode (120) comprises the absorbent element (121).

6. The detection structure (1) according to claim 5 taken in combination with claim 3 or 4, wherein the absorbent element (121) of the at least one absorbent element comprises at least one layer made of a "mid-gap" metal for the third zone (113).

7. The detection structure (1) according to any one of claims 1 to 6, wherein the transistor (100) further includes a metal contact for the second zone (112).

8. The detection structure (1) according to claim 7 taken alone or in combination with any one of claims 2 to 6, wherein the metal contact of the second zone (112) includes the absorbent element (125).

9. The detection structure (1) according to any one of claims 1 to 8, wherein the absorbent element (121, 125) comprises a conductive layer supported by at least one insulating layer (133, 132), the metal of the metal layer and the thicknesses of said metal layer and of the at least one insulating layer (133, 132) supporting it being selected so as to respect the following inequalities:

$$150\Omega \leq \frac{\rho}{Ep} \leq 700\Omega$$

with $\rho$ the equivalent resistivity of said layers and $Ep$ the sum of the thicknesses of said layers.

10. The detection structure (1) according to any one of claims 1 to 9, wherein the gate electrode (120) also covers the first zone and forms a metal contact of said first zone (111).

11. A method for manufacturing a bolometer type detection structure (10) for detecting an electromagnetic radiation, the manufacturing method comprising the following steps:

    - providing a second zone (112) of a first type of conductivity, said second zone (112) extending along an absorption plane, the second zone being formed by a second layer,
    - forming a third zone (113) in contact with the second zone (112), said third zone (113) being of a second type of conductivity which is opposite to the first type of conductivity with a majority carrier concentration which is lower than that of the second zone (112), the third zone (113) being formed by a third layer,
    - forming a first zone (111) in contact with the third layer (113A), the first zone (111) being of the first type of conductivity with a majority carrier concentration which is greater than that of the third zone (113) and being formed by a first layer, such that each of the first layer, the second layer, and the third layer extend parallel to an absorption plane and that the first, third and second layers follow each other in a direction perpendicular to said absorption plane, each of said first, second and third zones (111, 112, 113) having, according to the thickness of the corresponding layer, at least one lateral wall,

- forming a gate electrode (120) covering the third zone along at least one lateral wall of said third zone so as to form a transistor (100) of the MOS-FET type comprising the first, second and third zones (111, 112, 113) and the gate electrode (120), the gate electrode (120) being arranged to bias the third zone (113),

the manufacturing method further comprising forming an absorbent element (121, 125) associated with the transistor (100) such that the transistor (100) is capable of detecting the temperature rise of said absorbent element during the absorption of the electromagnetic radiation, said absorbent element (121,125) defining the absorption plane.

12. The manufacturing method according to claim 11, wherein the steps of providing and forming the first, second and third zones (111, 112, 113) are concomitant, said provision and said formations being carried out by an etching of a stack comprising second, third and first layers (111P, 112P, 113P).

13. The manufacturing method according to claim 11, wherein the second zone (112) is provided prior to the formation of the third and first zones (113, 111), the third zone being formed by a selective deposition on at least one portion of the second zone (112) and the first zone (111) being formed by a selective deposition on at least one portion of the third zone (113).

FIG. 1

FIG. 2A

FIG. 2B

112P
133P
410

FIG. 3A

411
112P
133P
410

FIG. 3B

113P
112P
133P
410

FIG. 3C

111P
113P
112P
133P
410

FIG. 3D

412
111P
113P
112P
133P
410

## FIG. 3E

111
113
112
133P
410

## FIG. 3F

131

111
113
112
133P
410

## FIG. 3G

131
132P
111
113
112
133P
410

# FIG. 3H

131
132P
451
111
113
112
133P
410

# FIG. 3I

121P
451
131
132P
111
113
112
133P
410

# FIG. 3J

131    132P    121P    122P

111
113
112
133P
410

## FIG. 3K

111 113 112   122 } 120    143P
           121

131 } 130
132
133P
410

## FIG. 3L

111 113 112  122 } 120  431  143P
         121

131 } 130
132
133P
410

## FIG. 3M

FIG. 4A

FIG. 4B

FIG. 4C

**FIG. 4D**

**FIG. 4E**

**FIG. 4F**

FIG. 4G

FIG. 4H

**FIG. 4I**

**FIG. 4J**

FIG. 4K

FIG. 4L

FIG. 4M

FIG. 4N

FIG. 4O

FIG. 4P

FIG. 4Q

FIG. 4R

FIG. 4S

FIG. 4T

411
112P
133P
410

## FIG. 5A

112
133P
410

## FIG. 5B

435
112
133P
410

## FIG. 5C

435
112
133P
410

## FIG. 5D

113 — 435
112
133P
410

# FIG. 5E

111 — 435
113 — 112
133P
410

# FIG. 5F

111 — 112
113 — 133P
410

# FIG. 5G

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2018055276 A1

**Littérature non-brevet citée dans la description**

- **L. GITELMAN.** *IEEE transaction on electron devices,* 2009, vol. 56 (9), 1935-1942